# EUROPÄISCHE PATENTSCHRIFT

(11) **EP 1 570 714 B1**
(45) Veröffentlichungstag und Bekanntmachung des Hinweises auf die Patenterteilung: **27.09.2006**
(21) Anmeldenummer: 04741999.9
(22) Anmeldetag: 16.07.2004
(51) Int. Cl.: H05K 13/04

(54) **GREIFEREINHEIT ZUM BESTÜCKEN VON SUBSTRATEN MIT ELEKTRISCHEN BAUELEMENTEN**
PLACEMENT UNIT FOR MOUNTING ELECTRIC COMPONENTS ONTO SUBSTRATES
UNITE DE PREHENSION POUR LA MISE EN PLACE DE COMPOSANTS ELECTRIQUES SUR DES SUBSTRATS

(30) Priorität: 05.09.2003 DE 10341069
(43) Veröffentlichungstag der Anmeldung: 07.09.2005
(73) Patentinhaber: SIEMENS AKTIENGESELLSCHAFT, 80333 München (DE)
(72) Erfinder: BURGER, Stefan, 81379 München (DE)
(86) Internationale Anmeldenummer: PCT/EP2004/051521
(87) Internationale Veröffentlichungsnummer: WO 2005/025287

(56) Entgegenhaltungen:
- WO-A-03/001572
- DE-A- 3 938 088
- DE-A- 19 514 686
- US-A- 5 410 801
- US-B1- 6 178 621

## Beschreibung

Die Erfindung bezieht sich auf eine Greifereinheit für elektrische Bauelemente zum Bestücken von Substraten mit den Bauelementen, wobei die Greifereinheit ein Gehäuse, einen darin drehbar gelagerten Halter für die Bauelemente sowie einen in dem Gehäuse gelagerten Drehantrieb für den Halter aufweist und wobei der Halter mit dem Drehantrieb über eine axial nachgiebige Kupplung drehfest verbunden ist.

Eine derartige Greifereinheit ist z.B. durch die US 6178621 B bekannt geworden. Eine derartige Greifereinheit ist Teil eines Bestückautomaten, bei dem elektrische Bauelemente in einem Zuführbereich bereitgestellt werden und in einem Bestückbereich auf eine elektrische Leiterplatte aufgesetzt werden. Zwischen dem Drehantrieb und dem Halter für die Bauelemente ist ein pneumatischer Puffer mit veränderbarem Arbeitsdruck vorgesehen. Dadurch ist es möglich, die Aufsetzkräfte je nach Bauelement auf unterschiedliche Höchstwerte einzustellen.

Ferner ist durch die WO 03/001572 A eine Greifereinheit bekannt geworden, bei der ein Drehantrieb mit dem Halter über einen seitlich auslenkbaren und in der Aufsetzrichtung zusammendrückbaren Metallbalg drehfest verbunden ist. Der Halter weist an seinem inneren Ende ein Ankerteil auf, das mittels Elektromagneten mit einer voreinstellbaren Magnetkraft beaufschlagt ist. Durch Änderungen in der Bestromung der Elektromagneten kann die Magnetkraft den zulässigen Höchstgrenzen der verschiedenen Bauelemente angepasst werden. Der Halter ist ferner in einem als Luftlager ausgebildeten Radialführungslager geführt, das keine Haftreibung aufweist. Bei der Bestimmung der Aufsetzkraft muss nicht nur die Magnetkraft, sondern auch die Federkraft des Metallbalgs berücksichtigt werden, sowie das Eigengewicht des Halters. Die Begrenzung der Aufsetzkraft ist besonders für kleine, druckempfindliche Bauelemente von Bedeutung.

Bei der aus US 5029383 bekannten Greifereinheit ist die Greiferspitze in einem hohlkugelförmigen Luftlager gelenkig und nahezu reibungsfrei gegenüber einem Halter gelagert, sodass sich die Greiferspitze beim Aufsetzen an die Form des aufzunehmenden Bauteils anpassen kann. Dabei wirkt auf das Bauteil nur die Gewichtskraft der Greiferspitze. Zum Aufnehmen des Bauteils wird das Luftlager und die Greiferspitze mit Unterdruck beaufschlagt, wodurch die Greiferspitze zusammen mit dem Bauteil an dem Halter fixiert werden.

Insbesondere bei Bauelementen mit einer größeren Anzahl von Anschlüssen ist aber auch eine gewisse Mindestkraft gefordert, um sicherzustellen, dass alle Anschlüsse vom Lotmaterial benetzt werden. Dies kann bedeuten, dass der zulässige Spielraum in einem engen Kraftbereich liegt.

Der Erfindung liegt die Aufgabe zugrunde, die unmittelbar am Bauelement wirksame Aufsetzkraft mit höherer Genauigkeit einhalten zu können.

Diese Aufgabe wird durch die Erfindung gemäß Anspruch 1 gelöst. Durch die Trennkupplung wird sichergestellt, dass die Kupplungselemente unmittelbar mit dem Aufsetzen des Bauelements auf das Substrat sicher entkoppelt werden. Durch diese vollständige Entkopplung des Halters vom Drehantrieb im Moment des Aufsetzens können von dieser Seite her keinerlei Kräfte mehr auf den Halter einwirken. Dabei geht man davon aus, dass sich das Bauelement nach dem Aufsetzen insbesondere bei den üblichen zähen Lotpasten nicht mehr verdreht. Bei der Einstellung der Aufsetzkraft brauchen daher keinerlei Kupplungs- oder Federkräfte berücksichtigt zu werden, was eine genauere und schnellere Einstellung ermöglicht. Insbesondere bedarf es keiner weiteren Regelung, um z. B. ansteigende Federkräfte auszugleichen. Der Drehantrieb kann z. B. als Direktantrieb einer Motorwelle, oder auch als bloße Antriebswelle ausgebildet sein, die z. B. über ein Getriebe mit einem Antriebsmotor in Verbindung steht.

Vorteilhafte Weiterbildungen der Erfindung sind in den Ansprüchen 2 bis 11 gekennzeichnet.

Das Drehen der Bauelemente in eine montagegerechte Lage erfordert lediglich ein geringes Drehmoment, das bereits durch eine gering vorgespannte Rutschkupplung sicher übertragen werden kann. Die entsprechend geringe Vorspannung entkoppelt auch die Drehachsen des Drehantriebs und des Halters voneinander, so dass dieser in einer eigenen Drehlagerung unbeeinflusst vom Drehantrieb genau geführt werden kann.

Durch die Weiterbildungen nach den Ansprüchen 3 und 4 ist es möglich, den Halter schnell zu wechseln. Derartige Halter können mit unterschiedlichen, an die Bauelemente angepassten Stirnseiten für die unmittelbar zu greifenden Bauelemente versehen sein.

Es ist aber auch möglich, die Bauelemente mittels einer angepassten Saugpipette zu greifen, die schnell wechselbar am Adapter des Halters angesetzt werden kann.

Durch die Weiterbildung nach Anspruch 6 kann die Winkeldrehung des Halters in unmittelbarer Nähe des Bauelements kontrolliert werden.

Durch die Weiterbildung nach Anspruch 7 wird die Leistungsfähigkeit der Bestückeinrichtung erheblich gesteigert.

Durch die Weiterbildung nach Anspruch 8 soll die Aufsetzkraft noch genauer kontrolliert werden können. Der hohlzylindrische dünnwandige Halter kann so leicht ausgebildet werden, dass sein Eigengewicht weit unter der geforderten Aufsetzkraft liegt und dass die auftretenden Massenkräfte entsprechend niedrig bleiben, so dass die Aufsetzkraft im Wesentlichen durch die einstellbare Druckeinrichtung bestimmt wird. Es ist üblich, nach dem Aufsetzen des Bauelementes auf das Substrat das Vakuum auf einen kurzen Druckimpuls umzuschalten, um ein sicheres Haften des Bauelements auf den Substrat zu gewährleisten. Es ist ferner üblich, die pneumatische Leitung durch eine zentrale Bohrung des Halters zur Saugspitze zu führen. Durch die Vergrößerung des Innenraums des Halters ergibt sich ein Puffervolumen, das die Durchleitung des Druckimpulses verzögert und damit die Bestückleistung verringern würde. Durch die Trennung der pneumatischen Leitung nach der Erfindung von diesem Innenraum wird deren Volumen erheblich verringert und das Vakuum an der Halterspitze kann in sehr kurzer Zeit auf einen gezielten Druckimpuls umgeschaltet werden.

Die Erfindung nach Anspruch 9 zielt ebenfalls darauf, die Aufsetzkraft noch genauer einstellen zu können. Das Luftlager ist sowohl in der Drehrichtung als auch in der axialen Verschieberichtung völlig reibungs- und hysteresefrei. Der Halter benötigt keine weiteren Lagerelemente, die seine Masse vergrößern könnten. Die axiale Druckbetätigung mittels des Druckgases (welche eine Druckeinrichtung darstellt) erfordert am Halter keine zusätzlichen Koppelelemente. Der Gasdruck verteilt sich gleichmäßig über die gesamte Querschnittsfläche des Halters, so dass der Kraftschwerpunkt im Zentrum liegt und keinerlei Kippmomente auftreten können. Der Gasdruck kann bereits vor dem Aufsetzen mittels eines Drucksensors genau auf einen vorgegebenen Wert eingestellt werden. In einer derartigen Kombination bleibt die geringe Haltermasse die einzige Störgröße, die jedoch durch eine geregelte Absenkgeschwindigkeit der Greifereinheit leicht beherrscht werden kann. Bei einer höheren Masse der ungefederten Teile wäre z.B. nach der eingangs genannten US6178621 B während des Aufsetzvorgangs eine Druckregelung erforderlich, die nach der vorliegenden Erfindung entfallen kann.

Durch die Entlüftungsnut nach Anspruch 10 wird das Luftlager vom Betätigungsdruck des Halters pneumatisch wirksam entkoppelt.

Durch die Weiterbildung nach Anspruch 11 wird das Druckvolumen über dem Halter so weit erhöht, dass eine Druckerhöhung beim Einfedern des Halters vernachlässigbar bleibt.

Im Folgenden wird die Erfindung anhand eines in der Zeichnung dargestellten Ausführungsbeispieles näher erläutert. Es zeigen:
- Figur 1: einen Längsschnitt durch eine Greifereinheit nach der Erfindung in einer Ausgangsstellung,
- Figur 2: einen partiellen Schnitt durch die Greifereinheit entlang der Linie II-II in Figur 1 in einer Funktionsstellung,
- Figur 3: einen Schnitt durch die Greifereinheit entlang der Linie 111-111 in Figur 2

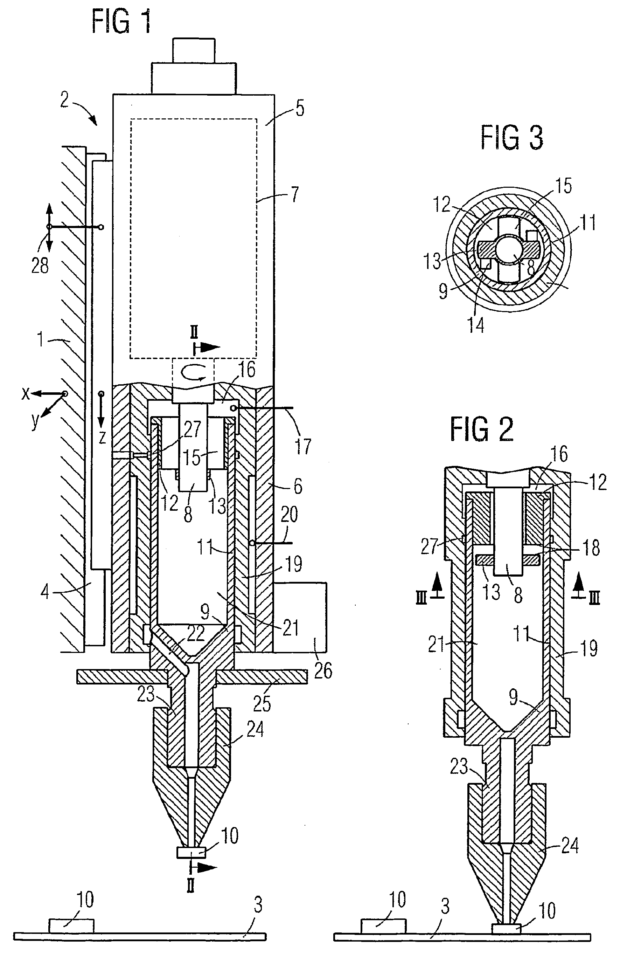

Nach den Figuren 1, 2 und 3 ist ein Träger 1 eines Bestückkopfes 2 in zwei waagerechten Koordinatenrichtungen X und Y parallel zu einem Substrat 3 verfahrbar. Der Träger ist mit einer senkrechten Linearführung 4 versehen, in der eine Greifereinheit 5 mittels eines Hubantriebs 28 des Trägers 1 in einer weiteren Koordinatenrichtung Z verschoben werden kann. In einem Gehäuse 6 der Greifereinheit 5 ist ein elektrischer Drehantrieb 7 aufgenommen, der mit einer Antriebswelle 8 in einen darunter koaxial angeordneten kolbenartigen Halter 9 für ein elektrisches Bauelement 10 eingreift. Der Halter 9 ist in einem zylindrischen Luftlager 11 drehbar und längs verschiebbar geführt.

Der im Wesentlichen hohlzylindrische Halter 9 weist auf seiner dem Drehantrieb 7 zugewandten Seite eine Stirnwand 12 auf, durch die die Antriebswelle 8 hindurchragt. Auf der dem Drehantrieb abgewandten Seite der Stirnwand 12 ist auf der Antriebswelle 8 eine Anschlagscheibe 13 fixiert, die mit seitlich flügelartig abstehende Schenkeln die Stirnwand hintergreift. In der in Figur 1 dargestellten Funktionsstellung liegt die Unterseite der Stirnwand 12 an der Oberseite von seitlich abstehenden Schenkeln der Anschlagscheibe 13 unter axialer Vorspannung an. Die Reibungskraft ist so groß, dass sie die Drehbewegung des Drehantriebs 7 auf den Halter 9 sicher überträgt, so dass das Bauelement 10 in der geforderten Drehlage auf das Substrat 3 aufgesetzt werden kann.

Die Stirnwand 12 weist einen Durchbruch 15 auf, der in seiner Kontur der Anschlagscheibe 13 mit Spiel angepasst ist und der sich senkrecht zur Längsrichtung der Anschlagscheibe 13 erstreckt. Dadurch ist es möglich, das Ende der Antriebswelle 8 mit der daran fixierten Anschlagscheibe 13 in einer um 90° verdrehten Montagestellung durch die Stirnwand 12 hindurchzuführen. Danach wird die Antriebswelle 8 relativ zum Halter 9 solange verdreht, bis die seitlichen Schenkel der Anschlagscheibe 13 an Drehanschläge 14 (in Figs. 1 und 3 nicht dargestellt) der Stirnwand 12 anliegen, so dass der Halter 9 mit der Antriebswelle in der Art eines Bajonettverschlusses verriegelt und gegen ein Absenken in der Koordinatenrichtung z gesichert ist.

Oberhalb der Stirnwand 12 ist in der Greifereinheit 5 ein geschlossener Hohlraum 16 ausgebildet, der mit einer angeschlossenen Druckluftleitung 17 verbunden ist. Die zugeführte Druckluft bildet eine Druckeinrichtung, die die Stirnwand 12 gegen die Anschlagscheibe 13 drückt. Die Stirnwand 12 und die Anschlagscheibe 13 bilden die Kupplungselemente einer Reibkupplung, bei der die einander zugewandten Seiten als Koppelflächen 18 dienen. Diese sind durch die pneumatische Druckkraft so stark gegeneinander verspannt, dass sie das zum Drehen des Halters 9 mit dem Bauelement 10 erforderliche geringe Moment sicher übertragen.

Das Luftlager 11 ist in einer Führungsbuchse 19 ausgebildet, die sich bis über den Hohlraum 16 erstreckt und die mit nicht dargestellten dünnen radialen Bohrungen versehen ist, die mit einer weiteren Druckluftleitung 20 verbunden sind. Zwischen diesem Bereich und dem oberen Ende des Halters 9 ist in der Führungsbuchse 19 eine umlaufende Entlüftungsnut 27 angeordnet, die ein unkontrolliertes Überströmen von Fehlluft zwischen den beiden Druckluftbereichen unterbindet, so dass die beiden Bereiche von gegenseitiger Druckbeeinflussung frei bleiben.

Der Halter 9 ist in seinem Führungsbereich als dünnwandiger Hohlzylinder ausgebildet, der einen entsprechend großvolumigen Innenraum 21 aufweist, so dass die Masse des Halters 9 sehr klein gehalten werden kann. Der Innenraum 21 ist von einer Vakuumleitung 22 zum Ansaugen des Bauelementes 10 an den Halter 9 durch einen geschlossenen Boden pneumatisch getrennt. Der Halter 9 weist an seinem unteren Ende einen Adapter 23 auf, auf den eine Saugpipette 24 angesetzt ist, die in ihrer Funktion dem Halter 9 zugeordnet ist. Es ist aber auch möglich, die Halterspitze selbst in der Art der Saugpipette auszubilden und das Bauelement 10 direkt daran anzusaugen.

Über dem Adapter 23 ist am Halter 9 eine scheibenförmige Winkelskala 25 angebracht, die mittels einer am Gehäuse 6 angebrachten stationären Tasteinrichtung 26 erfasst wird. Dadurch kann die Drehung des Halters 9 durch den Drehantrieb 7 in unmittelbarer Nähe des Bauelements 10 gemessen werden, so dass eventuelle Übertragungsfehler ohne Einfluss bleiben.

Nach Figur 2 ist die Greifereinheit 2 durch den Hubantrieb 28 in der z-Richtung soweit abgesenkt, dass das Bauelement 10 auf das Substrat 3 aufsitzt. In diesem Moment wird der Halter 9 in den Hohlraum 16 hineingedrückt, wobei der herrschende Gasdruck die maximale Aufsetzkraft bestimmt. Dabei ist es von Vorteil, dass der steuerbare Gasdruck bereits vorher genau eingestellt werden kann. Unterschiedliche Bauelemente erfordern eine unterschiedliche Aufsetzkraft, die durch unterschiedliche Druckbeaufschlagung erreicht wird. Im Moment des Einfederns des Halters 9 wird dieser gestoppt und in die restliche Greifereinheit hineingedrückt. Diese Relativbewegung kann durch einen geeigneten Sensor detektiert werden, der ein sofortiges Abbremsen der Hubbewegung auslöst. Unmittelbar mit dem Aufsetzen wird die Stirnwand 12 von der Anschlagscheibe 13 vollständig getrennt, so dass keine weiteren Massenkräfte und Kopplungskräfte auf den Halter 9 einwirken.

### Bezugszeichen

- x, y, z: Koordinatenrichtung
- 1: Träger
- 2: Bestückkopf
- 3: Substrat
- 4: Linearführung
- 5: Greifereinheit
- 6: Gehäuse
- 7: Drehantrieb
- 8: Antriebswelle
- 9: Halter
- 10: Bauelement
- 11: Luftlager
- 12: Stirnwand
- 13: Anschlagscheibe
- 14: Drehanschlag
- 15: Durchbruch
- 16: Hohlraum
- 17, 20: Druckluftleitung
- 18: Koppelfläche
- 19: Führungsbuchse
- 21: Innenraum
- 22: Vakuumleitung
- 23: Adapter
- 24: Saugpipette
- 25: Winkelskala
- 26: Tasteinrichtung
- 27: Entlüftungsnut
- 28: Hubantrieb

## Patentansprüche

1. Greifereinheit (5) zum Bestücken von Substraten (3) mit elektrischen Bauelementen (10),
wobei die senkrecht zum Substrat verschiebbare Greifereinheit (5) ein Gehäuse (6), einen darin drehbar gelagerten Halter (9) für die Bauelemente (10) sowie einen in dem Gehäuse (6) gelagerten Drehantrieb (7) für den Halter (9) aufweist und wobei der Halter (9) mit dem Drehantrieb (7) über eine axial nachgiebige Kupplung zumindest temporär drehfest verbunden ist, und wobei der Halter (9) gegen den Drehantrieb (7) durch eine einstellbare Druckeinrichtung axial zum Bauelement (10) hin vorgespannt ist,
**dadurch gekennzeichnet, dass** die Kupplung als Trennkupplung mit in der Achsrichtung entkoppelbaren Kupplungselementen (12, 13) ausgebildet ist, und dass die Koppelflächen (18) der Kupplungselemente (12, 13) einen axialen Anschlag für den Halter (9) bilden und dass die Koppelflächen (18) durch eine auf den Halter (9) einwirkende, die axiale Vorspannung überwindende axiale Aufsetzkraft voneinander abheben.

2. Greifereinheit nach Anspruch 1,
**dadurch gekennzeichnet, dass** die Kupplung als Reibkupplung mit sich senkrecht zur Drehachse erstreckenden Koppelflächen (18) der Kupplungselemente (12, 13) ausgebildet ist.

3. Greifereinheit nach Anspruch 1 oder 2,
**dadurch gekennzeichnet, dass** die Kupplung schnell trennbar ausgebildet und der Halter (9) austauschbar ist.

4. Greifereinheit nach einem der Ansprüche 1 bis 3,
**dadurch gekennzeichnet, dass** der Halter (9) im Gehäuse (6) axial verschiebbar gelagert ist und in der Art eines Bajonettverschlusses mit einer Antriebswelle (8) des Drehantriebs (7) verbunden ist.

5. Greifereinheit nach einem der vorhergehenden Ansprüche,
**dadurch gekennzeichnet, dass** der Halter (9) einen Adapter (23) zum lösbaren Ansetzen einer Saugpipette (24) für das Bauelement (10) aufweist.

6. Greifereinheit nach einem der vorhergehenden Ansprüche,
**dadurch gekennzeichnet, dass** der Halter (9) mit einer Winkelskala (25) versehen ist und
dass am Gehäuse (6) eine Tasteinrichtung (26) für die Winkelskala (25) vorgesehen ist.

7. Greifereinheit nach einem der vorhergehenden Ansprüche,
**dadurch gekennzeichnet, dass** mehrere der zueinander parallelen, einzeln betätigbaren Greifereinheiten (5) in einem mobilen Bestückkopf (2) zusammengefasst sind.

8. Greifereinheit nach einem der vorhergehenden Ansprüche,
**dadurch gekennzeichnet, dass** der weitgehend hohlzylindrische Halter (9) an seiner Mantelfläche dünnwandig ausgebildet ist und dass eine Vakuumleitung (22)c zum freien Halterende vom hohlzylindrischen Innenraum (21) des Halters (9) pneumatisch getrennt ist.

9. Greifereinheit nach einem der vorhergehenden Ansprüche,
**dadurch gekennzeichnet, dass** der Halter (9) in einem Zylindrischen Luftlager (11) drehbar und axial verschiebbar gelagert ist, und
dass der Halter (9) auf der dem Drehantrieb (7) zugewandten Seite in der Art eines Druckkolbens mit druckverstellbarem Gas beaufschlagbar ist.

10. Greifereinheit nach Anspruch 9,
**dadurch gekennzeichnet, dass** zwischen einem Luftspalt des Luftlagers (11) und dem vom Gas beaufschlagten Abschnitt des Halters (9) eine umlaufende Entlüftungsnut (27) vorgesehen ist.

11. Greifereinheit nach Anspruch 9 oder 10,
**dadurch gekennzeichnet, dass** der hohlzylindrische Innenraum (21) des Halters (9) pneumatisch mit der Druckseite des Halters (9) verbunden ist.

## Claims

1. Placement unit (5) for mounting electric components (10) onto substrates (3),
the placement unit (5), which can be moved perpendicularly to the substrate, having a housing (6), a built-in, rotatable holder (9) for the components (10) and, mounted within the housing (6), a rotary drive (7) for the holder (9), said holder (9) being connected via an axially elastic coupling to the rotary drive (7) in a manner which is, temporarily at least, torsionally rigid, and with the holder (9) being prestressed axially toward the component (10) against the rotary drive (7) by an adjustable pressure device,
**characterised in that**
the coupling is designed as a separable coupling having coupling elements (12, 13) that can be uncoupled in the axial direction, and that the coupling surfaces (18) of the coupling elements (12, 13) form an axial stop for the holder (9), and
that the coupling surfaces (18) separate from one another by an axial application force that acts on the holder (9) and prevails over the axial pre-stress.

2. Placement unit according to claim 1,
**characterised in that**
the coupling is designed as a friction clutch having coupling surfaces (18) of the coupling elements (12, 13) extending perpendicularly to the axis of rotation.

3. Placement unit according to claim 1 or 2,
**characterised in that**
the coupling is designed so that it can be rapidly separated and the holder (9) can be exchanged.

4. Placement unit according to one of the claims 1 to 3,
**characterised in that**
the holder (9) is mounted in the housing (6) in such a way that it can be moved axially, and is connected in the manner of a bayonet fastening to a drive shaft (8) of the rotary drive (7).

5. Placement unit according to one of the preceding claims,
**characterised in that**
the holder (9) has an adapter (23) for attaching a detachable suction pipette (24) for the component (10).

6. Placement unit according to one of the preceding claims,
**characterised in that**
the holder (9) is provided with an angle scale (25) and that a sensor (26) for the angle scale (25) is provided on the housing (6).

7. Placement unit according to one of the preceding claims,
**characterised in that**
a plurality of individually controllable placement units (5) are arranged in parallel in a movable placement head (2).

8. Placement unit according to one of the preceding claims,
**characterised in that**
the mainly hollow, cylindrical holder (9) is designed to be thin-walled in its cylindrical surface area, and that a vacuum line (22)c to the free end of the holder is pneumatically separated from the hollow, cylindrical interior (21) of the holder (9).

9. Placement unit according to one of the preceding claims,
**characterised in that**
the holder (9) is mounted in a cylindrical air bearing(11) in a rotatable and axially moveable manner and that the holder (9) at the end facing the rotary drive (7) can be impinged upon by a pressure-adjustable gas in the manner of a pressure piston.

10. Placement unit according to claim 9,
**characterised in that** a surrounding ventilation slot (27) is provided between an air gap of the air bearing (11) and the section of the holder (9) impinged upon by the gas.

11. Placement unit according to claim 9 or 10,
**characterised in that**
the hollow, cylindrical interior (21) of the holder (9) is pneumatically connected to the pressurised end of the holder (9).

## Revendications

1. Unité de saisie (5) pour la mise en place de composants électriques (10) sur des supports (3),
l'unité de saisie (5) pouvant être déplacée perpendiculairement par rapport au support et présentant un boîtier (6) dans lequel un dispositif de maintien (9) des composants (10) est monté à rotation ainsi qu'un entraînement de rotation (7) du dispositif de maintien (9) monté dans le boîtier (6), le dispositif de maintien (9) étant relié au moins temporairement à rotation solidaire à l'entraînement de rotation (7) par l'intermédiaire d'un accouplement déformable axialement, le dispositif de maintien (9) étant précontraint axialement par un dispositif réglable de poussée par rapport au composant (10) en opposition à l'entraînement de rotation (7),
**caractérisée en ce que**
l'accouplement est configuré comme accouplement de séparation qui présente des éléments d'accouplement (12, 13) qui peuvent être désaccouplés dans la direction axiale, **en ce que** les surfaces d'accouplement (18) des éléments d'accouplement (12, 13) forment une butée axiale pour le dispositif de maintien (9) et **en ce que** les surfaces d'accouplement (18) se séparent l'une de l'autre par une force axiale de mise en place qui agit sur le dispositif de maintien (9) et qui surmonte la précontrainte axiale.

2. Unité de saisie selon la revendication 1, **caractérisée en ce que** l'accouplement est configuré comme accouplement à frottement dont les surfaces d'accouplement (18) des éléments d'accouplement (12, 13) s'étendent perpendiculairement à l'axe de rotation.

3. Unité de saisie selon les revendications 1 ou 2,
**caractérisée en ce que** l'accouplement est configuré de manière à pouvoir être séparé rapidement et de telle sorte que le dispositif de maintien (9) puisse être remplacé.

4. Unité de saisie selon l'une des revendications 1 à 3, **caractérisée en ce que** le dispositif de maintien (9) est monté dans le boîtier (6) de manière à pouvoir coulisser axialement et est relié à un arbre d'entraînement (8) de l'entraînement à rotation (7) par une fermeture de type à baïonnette.

5. Unité de saisie selon l'une des revendications précédentes, **caractérisée en ce que** le dispositif de maintien (9) présente un adaptateur (23) qui permet de mettre en place de manière libérable une pipette aspirante (24) pour le composant (10).

6. Unité de saisie selon l'une des revendications précédentes, **caractérisée en ce que** le dispositif de maintien (9) est doté d'une échelle angulaire (25) et **en ce que** sur le boîtier (6) est prévu un dispositif de palpage (26) pour l'échelle angulaire (25).

7. Unité de saisie selon l'une des revendications précédentes, **caractérisée en ce que** plusieurs des unités de saisie (5) parallèles les unes aux autres et aptes à être actionnées individuellement, sont rassemblées dans une tête mobile de mise en place (2).

8. Unité de saisie selon l'une des revendications précédentes, **caractérisée en ce que** le dispositif de maintien (9) essentiellement en cylindre creux présente une surface d'enveloppe en paroi mince et **en ce qu'**un conduit en dépression (22) qui conduit à l'extrémité libre du dispositif de maintien est séparé pneumatiquement de l'espace intérieur (21) cylindrique creux du dispositif de maintien (9).

9. Unité de saisie selon l'une des revendications précédentes, **caractérisée en ce que** le dispositif de maintien (9) est monté de manière à pouvoir tourner et à être déplacé axialement dans un palier pneumatique cylindrique (11) et **en ce que** le dispositif de maintien (9) peut être sollicité par un gaz à pression réglable, à la manière d'un piston de poussée, sur un côté du dispositif de maintien tourné vers l'entraînement en rotation (7).

10. Unité de saisie selon la revendication 9, **caractérisée en ce qu'**entre un interstice d'air du palier pneumatique (11) et la partie du dispositif de maintien (9) qui peut être sollicitée par le gaz est prévue une rainure périphérique d'évacuation d'air (27).

11. Unité de saisie selon les revendications 9 ou 10, **caractérisée en ce que** l'espace intérieur cylindrique creux (21) du dispositif de maintien (9) est relié pneumatiquement au côté sous pression du dispositif de maintien (9).
